# EUROPEAN PATENT SPECIFICATION

(11) **EP 0 932 330 B1**
(45) Date of publication and mention of the grant of the patent: **28.11.2001**
(21) Application number: 98300550.5
(22) Date of filing: 27.01.1998
(51) Int. Cl.: H05K 7/20

(54) **Electronic apparatus**
Elektronisches Gerät
Appareil électronique

(43) Date of publication of application: 28.07.1999
(73) Proprietor: Lucent Technologies Inc., Murray Hill, New Jersey 07974-0636 (US)
(72) Inventor: Gates, William George, Wolverton, Milton Keynes, MK12 5DX (GB)
(74) Representative: Williams, David John

(56) References cited:
- FR-A- 2 533 364
- US-A- 4 012 089
- US-A- 5 587 880

## Description

This invention relates to electronic apparatus contained in a heat dissipative external enclosure.

In the absence of forced convection, electronic apparatus will be hotter at the top of its external enclosure than at the bottom. The situation is worse for apparatus which is sealed for use outside where internally generated heat has to be dissipated by the external enclosure. Ideally components which generate large amounts of heat would be sited lower in the external enclosure than components which generate less heat. That is not always possible.

Heat pipes have been used to conduct heat away from components to cooler positions in the external enclosure. Conventionally, the evaporator of a heat pipe is in direct thermal contact with a power component e.g. by clamping or bonding. The condenser is conventionally pressed into a groove in the wall of the external enclosure, being an interference fit in the groove so as to ensure good thermal contact. The heat pipe has a round cross section and the groove has a corresponding round bottom. The step of pressing the heat pipe into the groove may also be used to distort the pipe so that it finishes flush with the top of the groove.

Removal of the heat pipe is virtually impossible which makes removal of the circuit board on which the component is mounted very difficult.

In some external enclosures individual units have to be isolated from one another against radio frequency (RF) interference by closed internal housings. It would be difficult to maintain the RF isolation round a heat pipe which would have to enter the internal housing.

From EP-A-0 917 418, which falls under Art. 54(3) EPC for the all the designated contracting States, there is known an electronic apparatus contained in a heat dissipative external enclosure, the external enclosure containing at least one unit contained in a thermally conductive internal housing providing RF isolation and mounted on a wall of the external enclosure in thermal contact therewith; a wall of the unit having therein a first recess receiving the evaporator of a heat pipe, the heat pipe being clamped between the external enclosure and the internal housing, the condenser of the heat pipe being lower, in use, than the evaporator, being received by a recess in the wall of the external enclosure and clamped therein by a clamp member.

Thus, the subject-matter of claim 1 differs from the state of the art known from the 54(3)'s document, which can be taken into account only insofar novelty is concerned, in that the heat pipe has a first plate bonded to its evaporator (see claim 1).

Against this background there is provided electronic apparatus contained in a heat dissipative external enclosure, the external enclosure containing at least one unit contained in a thermally conductive internal housing providing RF isolation and mounted on a wall of the external enclosure in thermal contact therewith; and
a heat pipe having a first plate bonded to its evaporator and a second plate bonded to its condenser, both bonds being thermally conductive, the first plate being mounted by fixings in thermal contact with the internal housing, the second plate being mounted by fixings in thermal contact with the wall of the external enclosure at a position lower, in use, than the first plate.

The heat pipe may be easily removed. The inner housing can maintain RF isolation.

For best effect, the first plate is preferably located adjacent one or more power components inside the internal housing.

The first plate is preferably mounted in a recess in the internal housing.

One embodiment of the invention will now be described, by way of example, with reference to the accompanying drawings, in which:

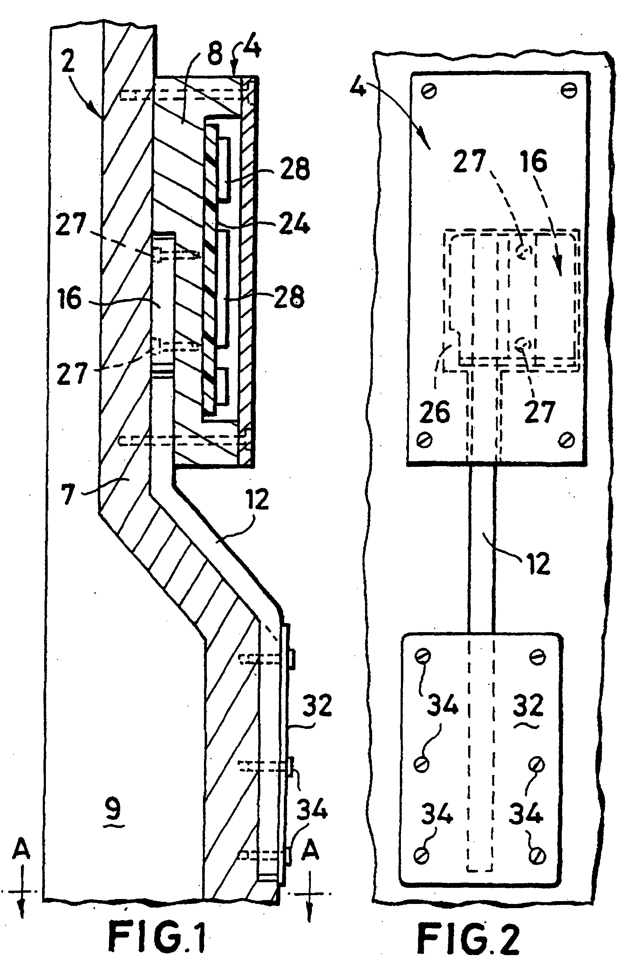

Figure 1 is a schematic section through part of electronic apparatus embodying the invention and showing an internal housing mounted on a wall of an external enclosure;

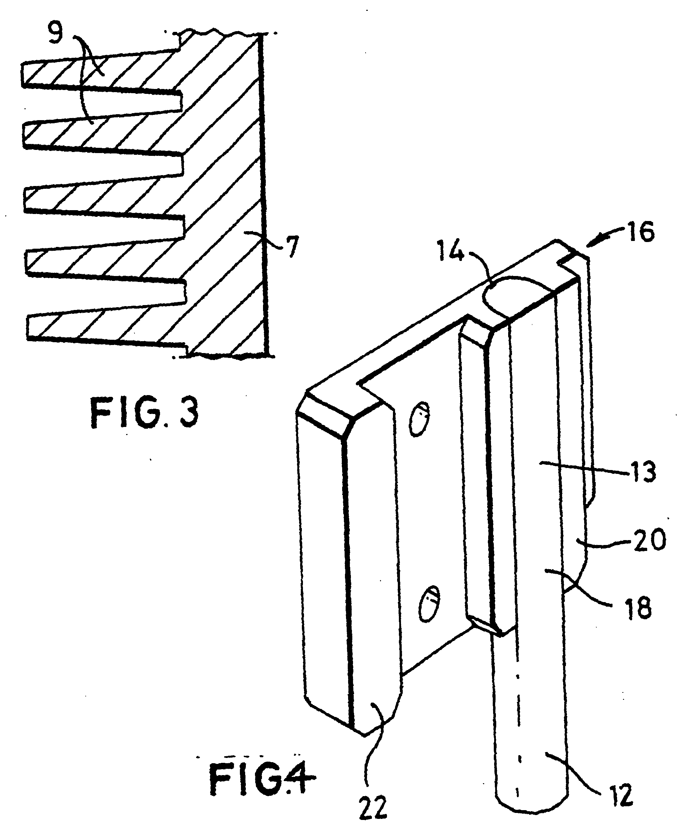

Figure 2 is a view of the internal housings taken from the right of Figure 1;
Figure 3 is a section on arrows A-A of Figure 1; and
Figure 4 is a perspective view of the evaporator of the heat pipe with its associated pipe.

Referring to the drawings, a base station of a mobile communications network has electronic apparatus mounted in an external enclosure 2, only part of which is shown in the drawings. The enclosure contains, amongst other units, a wide band power amplifier 4, contained by an aluminium internal housing 8 to provide RF isolation. The internal units, including the power amplifier 8 are mounted in thermal contact with a wall 7 of the enclosure 2. The enclosure 2 is manufactured from light metal and has extended surfaces or fins 9 so as to dissipate heat generated by its internal units including the power amplifier 4.

The enclosure 2 is environmentally sealed. Convection within the enclosure is not possible due to very small internal spaces left by the units contained therein. Convection round the external enclosure is not forced so the top of the enclosure is hotter significantly than the bottom. A relatively large amount of heat is generated by the power amplifier 4 and it would be better to locate the power amplifier low in the external enclosure in a lower temperature. Other design constraints require the power amplifier 4 to be located higher than desirable, however.

In order to reduce the temperature of the power amplifier 4, a heat pipe 12 is provided. The evaporator 13 of the heat pipe 12 is received by a recess 14 in a heat conductive plate 16 made, for example, of copper. The heat pipe 12 is bonded to the plate by pressing it into the recess to give a generally flat surface which is then machined flat with the a surrounding land 20 and with a land 22 spaced therefrom. Heat transfer between the evaporator 13 and the plate 16 may be enhanced by welding, brazing, soldering, or bonding with a heat conducting cement, such as epoxy resin, for example.

Inside the housing 8, components are mounted on a circuit board 24. The plate 16 is located in a recess 26 with the flat surface 13,20 adjacent power components 28, such as output transistors, which dissipate large amounts of heat. The plate 16 is mounted in thermal contact with the bottom of the recess 26 by fixings in the form of screws 27. The land 22 stabilises the plate laterally.

The condenser 30 of the heat pipe 12 is bonded to a heat conductive plate 32 e.g. by welding, brazing, soldering, or bonding with a heat conducting cement, such as epoxy resin, for example. The plate is secured in thermal contact with the to the wall 7 by fixings in the form of screws 34.

Heat is conducted by the heat pipe from the power amplifier 4 to a cooler lower section of the external enclosure.

## Claims

1. Electronic apparatus contained in a heat dissipative external enclosure (2), the external enclosure containing at least one unit (4) contained in a thermally conductive internal housing (8) providing RF isolation and mounted on a wall (7) of the external enclosure in thermal contact therewith;
a heat pipe (12) having a first plate (16) bonded to its evaporator (13) and a second plate (32) bonded to its condenser (30), both bonds being thermally conductive, the first plate being mounted by fixings in thermal contact with the internal housing, the second plate being mounted by fixings in thermal contact with the wall of the external enclosure at a position lower, in use, than the first plate.

2. Electronic apparatus as claimed in claim 1, wherein the first plate (16) is located adjacent one or more power components inside the internal housings (8).

3. Electronic apparatus as claimed in claim 1 or 2, wherein the first plate (16) is mounted in a recess (26) in the internal housing.

## Patentansprüche

1. Elektronisches Gerät, das in einer wärmeabführenden äußeren Umhüllung (2) enthalten ist, wobei die äußere Umhüllung wenigstens eine Einheit (4) enthält, die in einem wärmeleitfähigen inneren Gehäuse (8) enthalten ist, das für HF-Isolierung sorgt und an einer Wand (7) der äußeren Umhüllung in Wärmeberührung mit dieser angebracht ist;
wobei ein Wärmerohr (12) eine erste Platte (16) aufweist, die mit dessen Verdampfer (13) verbunden ist, sowie eine zweite Platte (32) aufweist, die mit dessen Kondensator (30) verbunden ist, wobei beide Verbindungen wärmeleitfähig sind, wobei die erste Platte durch Fixiereinrichtungen in Wärmeberührung mit dem inneren Gehäuse angebracht ist und die zweite Platte durch Fixiereinrichtungen in Wärmeberührung mit der Wand der äußeren Umhüllung an einer im Gebrauch niedrigeren Stelle als die erste Platte angebracht ist.

2. Elektronisches Gerät nach Anspruch 1,
wobei die erste Platte (16) sich in der Nähe von einer oder mehreren Leistungskomponenten im Inneren des inneren Gehäuses (8) befindet.

3. Elektronisches Gerät nach Anspruch 1 oder 2,
wobei die erste Platte (16) in einer Aussparung (26) in dem inneren Gehäuse angebracht ist.

## Revendications

1. Appareil électronique contenu dans une enceinte extérieure (2) dissipant la chaleur, l'enceinte extérieure contenant au moins une unité (4) contenue dans un boîtier intérieur (8) conducteur de la chaleur assurant une isolation RF et monté sur une paroi (4) de l'enceinte extérieure en contact thermique avec elle ;
un caloduc (12) ayant une première plaque (16) liée à son évaporateur (13) et une seconde plaque (32) liée à son condenseur (30), les deux liaisons étant conductrices de la chaleur, la première plaque étant montée par des organes de fixation en contact thermique avec le boîtier intérieur, la seconde plaque étant montée par des organes de fixation en contact thermique avec la paroi de l'enceinte extérieure dans une position plus basse, lors de l'utilisation, que celle de la première plaque.

2. Appareil électronique selon la revendication 1, dans lequel la première plaque (16) est placée de façon à être adjacente à un ou plusieurs composants de puissance à l'intérieur du boîtier intérieur (8).

3. Appareil électronique selon la revendication 1 ou 2, dans lequel la première plaque (16) est montée dans un évidement (26) dans le boîtier intérieur.
